# DEMANDE DE BREVET EUROPEEN

(11) **EP 4 811 956 A1**
(43) Date de publication de la demande: **23.09.2026**
(21) Numéro de dépôt: 26162635.2
(22) Date de dépôt: 05.03.2026
(51) Int. Cl.: H10D 30/60, H10D 30/01, H10D 64/27

(54) **TRANSISTORS MOS A DOUBLE GRILLE ET PROCEDE DE FABRICATION**

(30) Priorité: 19.03.2025 FR 2502815
(71) Demandeur: STMicroelectronics International N.V., 1228 Plan-les-Ouates, Geneva (CH)
(72) Inventeur: ARRAZAT, Brice, 13720 BELCODENE (FR); RIVERO, Christian, 13790 PEYNIER (FR); INNOCENTI, Jordan, 13600 LA CIOTAT (FR)
(74) Mandataire: Cabinet Beaumont

(57) **Abrégé**

La présente description concerne un transistor MOSFET (200) situé dans et sur un substrat semiconducteur et comportant :
- une zone active (110) du substrat le long d'une première direction (X) du plan (XY) du substrat ; et
- une structure de grille (220) comprenant une première région (221) au-dessus de la zone active et une deuxième région (222) au-dessus de la première région ;

la première région a une première longueur (L21), la deuxième région a une deuxième longueur (L22) supérieure à la première longueur et déborde de part et d'autre de la première région dans la première direction ;
la deuxième région a un premier bord longitudinal (222a) qui déborde d'un deuxième bord longitudinal (221a) de la première région dans la deuxième direction (Y) du plan ;
la deuxième région présente une ouverture (224) qui s'étend dans la deuxième direction à partir d'un troisième bord longitudinal (222b) de ladite deuxième région opposé au premier bord longitudinal.

## Description

### Domaine technique

La présente description concerne de façon générale les circuits électroniques, et en particulier les transistors MOS. La présente description concerne en particulier les transistors MOS à double région de grille, ou double grille.

### Technique antérieure

Les transistors à effet de champ métal oxyde semiconducteur, ou MOSFET, de l'anglais "Metal Oxide Semiconductor Field Effect Transistor" sont des transistors comprenant une région de grille conductrice électriquement isolée d'un substrat semiconducteur, généralement en silicium, ou d'un caisson formé dans un substrat semiconducteur, par une couche diélectrique appelée oxyde de grille ou isolant de grille, la région de grille surmontant une zone active comprenant une région de source, une région de drain et une région de formation de canal entre la région de source et la région de drain. Un MOSFET peut être désigné transistor MOS, par raccourci.

Les transistors MOS à canal N, ou transistors NMOS, désignent des transistors dont les régions de source et de drain sont dopées de type N, par exemple dopées d'atomes d'arsenic ou de phosphore. Les transistors MOS à canal P, ou transistors PMOS, désignent des transistors dont les régions de source et de drain sont dopées de type P, par exemple dopées d'atomes de bore ou d'indium.

La présente description concerne particulièrement les transistors MOS à double région de grille, c'est-à-dire des transistors MOS dont la structure de grille comprend une première région de grille surmontée par une deuxième région de grille, avec, généralement, une couche isolante entre ces deux régions de grille.

Les transistors MOS à double région de grille peuvent être configurés notamment pour former des transistors MOS capables de tenir une tension moyenne (transistors de tension moyenne, ou transistors MV MOS), par exemple entre 10 et 13 volts, entre le drain et le substrat semiconducteur, voire des transistors MOS capables de tenir une haute tension (transistors de haute tension, ou transistors HV MOS) entre le drain et le substrat semiconducteur, par exemple supérieure à 14 volts, en permettant notamment d'augmenter la distance d'implantation entre la source et le canal et entre le drain le canal, et en permettant d'augmenter la tension de claquage (BV, de l'anglais "breakdown voltage").

Des transistors à double région de grille peuvent, par exemple, être utilisés dans des cellules de mémoire non volatile. Une cellule mémoire non volatile, par exemple du type électriquement effaçable et programmable, connu sous l'acronyme EEPROM, de l'anglais "Electrically-Erasable Programmable Read-Only Memory", comporte un transistor d'état à double région de grille, généralement une région de grille de commande surmontée d'une région de grille flottante. Le transistor d'état peut être sélectionnable par l'intermédiaire d'un transistor de sélection relié en série au transistor d'état. Pour des raisons de simplification du procédé de fabrication de la cellule mémoire, il est plus aisé de réaliser un transistor de sélection comprenant un transistor à double région de grille dont les deux régions de grilles sont de préférence connectées entre elles de sorte à ne former qu'une seule grille.

En général, un transistor MOS moyenne ou haute tension présente une structure planaire coûteuse en termes d'encombrement surfacique. En particulier, un transistor MOS haute tension peut présenter une structure planaire avec un drain étendu, dit "drift MOS" en anglais, de façon à présenter une tension de claquage (BV) élevée. Toutefois, un transistor MOS à drain étendu s'avère être très coûteux en termes d'encombrement surfacique.

### Résumé de l'invention

Il existe un besoin de diminuer l'empreinte surfacique d'un transistor MOS tout en offrant des performances électriques équivalentes ou supérieures à celles d'un transistor MOS connu, en particulier pour un transistor MV MOS ou HV MOS.

Un mode de réalisation pallie tout ou partie des inconvénients des transistors MOS connus.

Un mode de réalisation prévoit un transistor MOSFET situé dans et sur un substrat semiconducteur s'étendant selon un plan, le transistor MOSFET comportant :
- une région de drain et une région de source situées dans une zone active du substrat semiconducteur le long d'une première direction du plan ; et
- une structure de grille comprenant une première région isolée de, et située au moins en partie au-dessus de, la zone active, et une deuxième région isolée de, et située au-dessus de, la première région ;

la première région ayant une première longueur, la deuxième région ayant une deuxième longueur supérieure à la première longueur, et la deuxième région débordant de part et d'autre de la première région dans la première direction ;
la deuxième région ayant un premier bord longitudinal qui atteint la limite, ou qui déborde, d'un deuxième bord longitudinal de la première région, dans une deuxième direction du plan perpendiculaire à la première direction ;
la deuxième région présentant une ouverture qui s'étend dans la deuxième direction à partir d'un troisième bord longitudinal de ladite deuxième région opposé au premier bord longitudinal.

Selon un mode de réalisation, la zone active a une troisième longueur supérieure à la deuxième longueur, et une troisième largeur inférieure à une première largeur de la première région et à une deuxième largeur de la deuxième région.

Selon un mode de réalisation, la première région de la structure de grille est positionnée sur une couche d'isolant de grille et est recouverte par une couche d'isolant inter-grilles, et la deuxième région de la structure de grille est positionnée à cheval, au moins dans la première direction, sur la première région recouverte par la couche d'isolant inter-grilles et sur la couche d'isolant de grille.

Selon un mode de réalisation, la première région est située de part et d'autre de la zone active dans la deuxième direction.

Selon un mode de réalisation, la deuxième région est située de part et d'autre de la zone active dans la deuxième direction.

Selon un mode de réalisation, l'ouverture de la deuxième région est une encoche qui s'arrête avant le premier bord longitudinal.

Selon un mode de réalisation, l'ouverture est une encoche qui s'arrête avant le deuxième bord longitudinal. En d'autres termes, l'encoche s'arrête au-dessus de la première région.

Selon un mode de réalisation, l'encoche s'arrête avant la zone active.

Selon un mode de réalisation, l'encoche s'étend, par exemple s'arrête, au-dessus de la zone active.

Selon un mode de réalisation, l'ouverture s'étend jusqu'au premier bord longitudinal, de sorte que la deuxième région est en deux parties séparées par l'ouverture.

Selon un mode de réalisation, la deuxième région déborde du deuxième bord longitudinal dans la deuxième direction, et la première région déborde du troisième bord longitudinal dans la deuxième direction.

Selon un mode de réalisation, la deuxième région déborde de part et d'autre de la première région dans la deuxième direction, une première largeur de la première région étant inférieure à une deuxième largeur de la deuxième région.

Selon un mode de réalisation, le transistor MOSFET comprend en outre un premier contact sur la première région et au moins un deuxième contact sur la deuxième région, par exemple un deuxième contact pour chaque partie d'une deuxième région en deux parties.

Selon un mode de réalisation, le transistor MOSFET comprend en outre au moins un contact partagé à cheval sur la première région et sur la deuxième région, par exemple un contact partagé pour chaque partie d'une deuxième région en deux parties.

Selon un mode de réalisation, le premier contact, ou le au moins un contact partagé, est positionné au moins partiellement dans l'ouverture.

Selon un mode de réalisation, la première région de la structure de grille est entre la région de drain et la région de source.

Selon un mode de réalisation, la deuxième région de la structure de grille est entre la région de drain et la région de source.

Selon un mode de réalisation, la région de drain et la région de source sont comprises chacune dans une région de drain faiblement dopée située au moins partiellement sous la deuxième région de la structure de grille.

Selon un mode de réalisation, la zone active est entourée de tranchées isolantes, les première et deuxième régions s'étendant également au-dessus desdites tranchées isolantes.

Selon un mode de réalisation, les première et deuxième régions de la structure de grille comprennent du, par exemple sont en, polysilicium.

Selon un mode de réalisation, le transistor MOSFET est un transistor de tension moyenne, par exemple entre 10 et 13 volts, ou un transistor de haute tension, par exemple supérieure à 14 volts.

Un mode de réalisation prévoit un procédé de fabrication d'au moins un transistor MOSFET, le procédé comprenant les étapes successives suivantes, pour chaque transistor MOSFET :
- la formation d'une première région d'une structure de grille, ladite première région étant isolée et au-dessus d'une zone active d'un substrat semiconducteur s'étendant selon un plan, ladite première région ayant une première longueur dans une première direction du plan ;
- la formation d'une deuxième région de la structure de grille, ladite deuxième région étant isolée et au-dessus de la première région, ayant une deuxième longueur supérieure à la première longueur, et débordant de part et d'autre de la première région dans la première direction, la deuxième région étant formée de sorte qu'un premier bord longitudinal de ladite deuxième région atteint la limite, ou déborde, d'un deuxième bord longitudinal de la première région, dans une deuxième direction du plan perpendiculaire à la première direction, et la formation de la deuxième région comprenant la formation d'une ouverture dans ladite deuxième région, dans la deuxième direction à partir d'un troisième bord longitudinal de ladite deuxième région opposé au premier bord longitudinal ; puis
- la formation de régions de drain et de source de part et d'autre de la deuxième région dans la première direction.

Selon un mode de réalisation, la première région de la structure de grille est positionnée sur une couche d'isolant de grille et est recouverte par une couche d'isolant inter-grilles, et la deuxième région de la structure de grille est positionnée à cheval, au moins dans la première direction, sur la première région recouverte par la couche d'isolant inter-grilles et sur la couche d'isolant de grille.

Selon un mode de réalisation, l'ouverture est une encoche qui s'arrête avant le deuxième bord longitudinal.

Selon un mode de réalisation, l'ouverture s'étend jusqu'au premier bord longitudinal, de sorte que la deuxième région est séparée en deux parties par l'ouverture.

Selon un mode de réalisation, le procédé de fabrication comprend en outre, après la formation de la première région, et avant la formation de la deuxième région, la formation de régions de drain faiblement dopées de part et d'autre de la première région dans la première direction.

Selon un mode de réalisation, la fabrication du au moins un transistor MOSFET comprend la fabrication de plusieurs transistors MOSFET de types différents choisis parmi : un transistor de tension moyenne, et/ou un transistor de haute tension, et/ou un transistor d'état d'une cellule mémoire, et/ou un transistor de sélection d'une cellule mémoire.

Selon un mode de réalisation, les premières régions desdits transistors sont formées simultanément.

Selon un mode de réalisation, les premières régions desdits transistors sont en le même matériau.

Selon un mode de réalisation, les deuxièmes régions desdits transistors sont formées simultanément.

Selon un mode de réalisation, les deuxièmes régions desdits transistors sont en le même matériau.

Selon un mode de réalisation, le procédé de fabrication comprend, avant la formation des premières régions des transistors MOSFET, la formation de couches d'isolant de grille de même matériau et de sensiblement la même épaisseur sur les zones actives des transistors MOSFET.

Selon un mode de réalisation, le procédé de fabrication comprend, après la formation des premières régions et avant la formation des deuxièmes régions des transistors MOSFET, la formation de couches oxyde-nitrure-oxyde de sensiblement la même épaisseur sur les premières régions des transistors MOSFET.

Un mode de réalisation prévoit un circuit électronique comprenant un substrat semiconducteur et au moins un transistor MOSFET comme décrit dans ce qui précède.

Selon un mode de réalisation, le circuit électronique est une mémoire non volatile du type électriquement effaçable et programmable.

Selon un mode de réalisation, le au moins un transistor MOSFET comprend plusieurs transistors MOSFET de types différents choisis parmi : un transistor de tension moyenne, et/ou un transistor de haute tension, et/ou un transistor d'état d'une cellule mémoire, et/ou un transistor de sélection d'une cellule mémoire ;
- les premières régions desdits transistors étant de préférence en le même matériau, les deuxièmes régions desdits transistors étant de préférence en le même matériau ; et/ou
- des couches oxyde-nitrure-oxyde de sensiblement la même épaisseur étant positionnées entre les premières régions et les deuxièmes régions desdits transistors ; et/ou
- des couches d'isolant de grille de même matériau et de sensiblement la même épaisseur étant positionnées entre les zones actives et les premières régions desdits transistors.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente, par une vue de dessus simplifiée et partielle, un exemple de transistor MOS ;
la figure 1B représente, par une vue de dessus simplifiée et partielle, un autre exemple de transistor MOS ;
la figure 2A représente, par une vue de dessus simplifiée et partielle, un transistor MOS selon un mode de réalisation ;
la figure 2B représente, par une vue de dessus simplifiée et partielle, un transistor MOS selon une variante de réalisation du transistor MOS de la figure 2A ;
la figure 2C représente, par une vue de dessus simplifiée et partielle, un transistor MOS selon une autre variante de réalisation du transistor MOS de la figure 2A ;
la figure 3A représente, par une vue de dessus simplifiée et partielle, un transistor MOS selon un autre mode de réalisation ;
la figure 3B représente, par une vue de dessus simplifiée et partielle, un transistor MOS selon une variante de réalisation du transistor MOS de la figure 3A ;
la figure 3C représente, par une vue de dessus simplifiée et partielle, un transistor MOS selon une variante de réalisation du transistor MOS de la figure 3B ; et
la figure 4A, la figure 4B, la figure 5A, la figure 5B, la figure 6A, la figure 6B, la figure 7A, la figure 7B, la figure 8A, la figure 8B, la figure 9A, la figure 9B, la figure 10A, la figure 10B, la figure 11A, et la figure 11B sont des vues en trois dimensions et en coupe longitudinale, illustrant de façon partielle et schématique des étapes successives d'un procédé de fabrication d'un transistor MOS selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits sont représentés et détaillés. En particulier, toutes les étapes du procédé de fabrication des transistors MOS ne sont pas décrites, étant réalisables avec les procédés usuels de la microélectronique. De même, tous les détails des transistors MOS ne sont pas décrits. En particulier, tous les contacts et les circuits d'interconnexion des transistors ne sont pas représentés. En outre, les applications que peuvent avoir les transistors MOS décrits ne sont pas toutes détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, les qualificatifs "isolant" et "conducteur" signifient respectivement, sauf précision contraire, électriquement isolant et électriquement conducteur.

Dans la description qui suit, pour alléger celle-ci, un transistor du type MOSFET peut être désigné transistor MOS, ou transistor.

Lorsqu'on fait référence à une "zone active", il est fait référence à une zone d'un substrat semiconducteur d'un transistor, par exemple, une zone délimitée par des régions d'isolation, telles que des tranchées isolantes. Une zone active comprend typiquement une région de source, une région de drain et une région de formation de canal, ou région de canal, entre la région de source et la région de drain.

Un substrat semiconducteur peut être un substrat massif, par exemple en silicium, une couche de semiconducteur d'un substrat du type silicium sur isolant (SOI, de "Silicium On Insulator" en anglais), ou un caisson semiconducteur.

Dans la description qui suit, une longueur correspond à une dimension dans une première direction, ou direction longitudinale, correspondant à la direction X repérée dans les figures, d'un plan XY. Le plan correspond sensiblement au plan principal du substrat semiconducteur dans, et sur, lequel le transistor est formé. La première direction X correspond à une direction parallèle à la direction de conduction du transistor, c'est-à-dire la direction de la région de formation de canal entre la région de source et la région de drain du transistor. Une largeur correspond à une dimension dans une deuxième direction, ou direction transversale, du plan XY, correspondant à la direction Y repérée dans les figures, orthogonale à la première direction. Une épaisseur ou une profondeur correspond à une dimension dans la direction perpendiculaire au plan XY, correspondant à la direction verticale Z repérée dans les figures. Le terme longitudinal fait référence à la première direction X, tandis que le terme transversal fait référence à la deuxième direction Y.

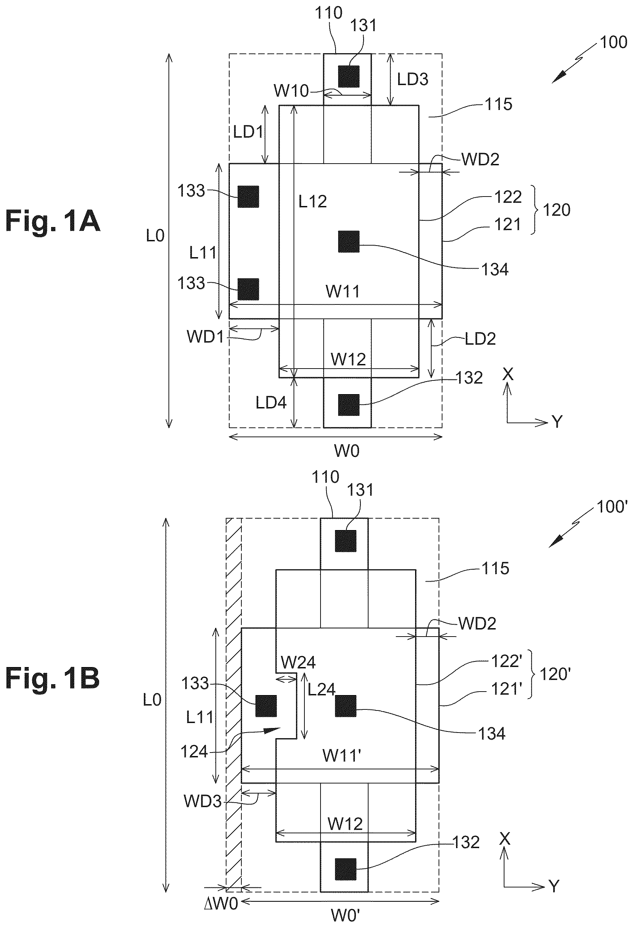

La figure 1A représente, par une vue de dessus simplifiée et partielle, un exemple de transistor MOS 100. Le transistor MOS 100, du type MV ou HV, est situé dans et sur une zone active 110 d'un substrat semiconducteur. La zone active 110 est entourée par une tranchée isolante 115, par exemple du type tranchée peu profonde, ou STI, de l'anglais "Shallow Trench Isolation". La zone active 110 comporte une région dopée de drain reliée à un contact 131 et une région dopée de source reliée à une contact 132. La région de drain et la région de source sont séparées par une région de canal, toutes ces régions étant ménagées dans le substrat semiconducteur. De façon classique les régions de drain et de source sont généralement siliciurées au moins en dessous des contacts 131, 132.

Dans le cas d'un transistor NMOS, les régions de drain et de source sont dopées N. Elles sont dopées P pour un transistor PMOS.

Le transistor 100 comporte également une structure de grille 120 isolée de la zone active 110 par une couche d'isolant de grille (non représentée), par exemple une couche d'oxyde.

La structure de grille 120 comporte une première région 121, de longueur L11 et de largeur W11, située au-dessus de la zone active 110, isolée du substrat semiconducteur par la couche d'isolant de grille. La structure de grille 120 comporte également une deuxième région 122, de longueur L12 et de largeur W12, située au-dessus de la première région 121 et isolée de celle-ci par une autre couche isolante (non représentée), qui peut être une couche dite ONO, pour Oxyde-Nitrure-Oxyde. Cette couche ONO provient du fait que, généralement, des transistors MOSFET du type MV ou HV sont réalisés avec des étapes de fabrication communes à celles d'autres transistors du type à grille flottante, qui comportent cette couche ONO, et ce, afin de réduire le nombre d'étapes totales de fabrication.

Par exemple, la première région 121 est adaptée au contrôle du transistor, tandis que la deuxième région 122 permet de régler la tension de claquage du transistor, notamment en jouant sur les longueurs des débords LD1 et LD2 décrits ci-dessous.

La longueur L11 est plus petite que la longueur L12, et la deuxième région 122 déborde de part et d'autre de la première région 121 dans la direction longitudinale X (première direction). En d'autres termes, la deuxième région 122 possède une zone centrale sur la première région 121 et deux parties LD1 et LD2 débordant de part et d'autre de la première région 121 dans la direction X.

La longueur L12 de la deuxième région 122 est ainsi égale à la somme de la longueur L11 de la première région 121 et des débords LD1 et LD2.

Les parties débordantes LD1 et LD2 dans la direction X de la deuxième région 122 permettent, lors du dopage des régions de drain et de source, de modifier le profil de dopage, notamment d'augmenter la distance entre les régions de drain et de source, dans la mesure où ce dopage est réalisé après la formation de la deuxième région 122. Cela permet de modifier les caractéristiques électriques du transistor 100, notamment d'augmenter sa tension de claquage (BV).

Les débords LD1 et LD2 peuvent être sensiblement égaux entre eux.

La zone active 110 s'étend de part et d'autre de la deuxième région 122 dans la direction longitudinale X, présentant un débord LD3 côté drain et un débord LD4 côté source, ces deux débords LD3 et LD4 pouvant être similaires. Ainsi, la longueur de la zone active 110, qui dans cet exemple est égal à la longueur L0 du transistor MOS 100, est supérieure à la longueur L12 de la deuxième région 122. Cela permet d'avoir des portions accessibles de la zone active 110 pour les contacts 131 et 132. La longueur L0 de la zone active 110 est égale à la somme de la longueur L12 et des débords LD3 et LD4.

La largeur W11 de la première région 121 est supérieure à la largeur W12 de la deuxième région 122, et la première région 121 déborde de part et d'autre de la deuxième région 122 dans la direction transversale Y (deuxième direction). En d'autres termes, la première région 121 possède une zone centrale sous la deuxième région 122 et deux parties WD1 et WD2 débordant de part et d'autre de la deuxième région 122 dans la direction transversale Y.

La largeur W11 de la première région 121 est ainsi égale à la somme de la largeur W12 de la deuxième région 122 et des débords WD1 et WD2.

Au moins une des parties débordantes WD1 et WD2 permet notamment de réaliser une connexion électrique de la première région 121. On a représenté par exemple deux contacts 133 sur la première région 121, et un contact 134 sur la deuxième région 122, ce nombre pouvant varier, et les contacts étant généralement formés sur des portions siliciurées de ces régions de grille.

La largeur W12 de la deuxième région 122 est elle-même plus grande que la largeur W10 de la zone active 110, la deuxième région 122 s'étendant de part et d'autre de la zone active 110 dans la direction transversale Y, ceci notamment afin d'éloigner les implantations, dans la zone active 110, de la région de source et de la région de drain, réalisées après la formation de la deuxième région 122, la portion non implantée de la zone active 110, sous la deuxième région 122, devant rester faiblement dopée. Ainsi, comme la première région 121 déborde de part et d'autre de la deuxième région 122 dans la direction transversale Y, la première région 121 déborde également de part et d'autre de la zone active 110 dans la direction transversale Y.

La fabrication d'un transistor MOS répond en général à des règles de conception, en particulier en termes de positionnement des contacts, en termes de distance entre les contacts et les bords des régions qu'ils connectent et/ou entre les contacts et d'autres régions, voire entre les régions de grille de deux transistors MOS adjacents, par exemple pour éviter des risques de court-circuit ou de courant de fuite, et/ou pour limiter la formation de capacités parasites. Par exemple, chaque contact 133 de la première région 121, qui n'est isolé de la région active 110 que par la couche d'isolant de grille, doit généralement respecter une limite de distance minimale par rapport aux bords de cette première région 121, pour être assuré que ce contact ne déborde pas au-delà des bords de cette première région de grille, en prenant en compte un risque de désalignement en fabrication, et/ou doit préférentiellement être positionné en dehors de la zone active 110, pour éviter tout risque de court-circuit entre le contact 133 et la zone active 110, qui peut être formé accidentellement lors de la fabrication du transistor. En outre, une distance minimale doit être respectée entre chaque contact 133 de la première région 121 et la deuxième région 122.

Les première et deuxième régions de grille 121 et 122 sont en général de matériau identique, par exemple en polysilicium.

En général, la deuxième région 122, voire les portions non recouvertes de la première région 121, comportent sur leurs flancs des régions latérales isolantes, ou espaceurs (non représentés).

Les deux régions de grille 121 et 122 sont dans cet exemple reliées entre elles, par exemple par leurs contacts 133, 134 et une métallisation située dans un premier niveau de métal d'une structure d'interconnexion, ou BEOL, (non représentée).

Selon un exemple non limitatif, les débords LD1 et LD2 sont chacun égaux à environ 260 nm, la longueur L11 de la première région 121 est égale à environ 700 nm, la longueur L12 de la deuxième région 122 est égale à environ 1,22 µm, le débord WD1 est égal à environ 260 nm, le débord WD2 est égal à environ 100 nm, la largeur W12 de la deuxième région 122 est égale à environ 620 nm, la largeur W11 de la première région 121 est égale à environ 980 nm, les débords LD3 et LD4 de la zone active 110 sont égaux à environ 225 nm, et la largeur W10 de la zone active 110 est égale à environ 220 nm. Ces dimensions sont prises comme exemple non limitatif, notamment dans le but d'indiquer plus après les gains sur l'empreinte surfacique que permettent les différents modes de réalisation décrits dans ce qui suit.

On constate que, compte tenu des règles de conception, pour réaliser un transistor MOS de type MV, voire HV, on se retrouve avec une empreinte surfacique importante de ce transistor MOS, ainsi que du dispositif électronique qui comporte plusieurs transistors MOS, pour lequel des règles d'espacement entre les transistors MOS peuvent s'appliquer. Par exemple, on peut vouloir prévoir un espacement de 0,20 µm dans la direction Y et de 0,50 µm dans la direction X.

En reprenant l'exemple de dimensions indiqué ci-dessus, le transistor MOS 100 occupe une largeur WO d'environ 0,98 µm et une longueur L0 d'environ 1,67 µm, soit une empreinte surfacique d'environ 1,63 µm² et ce, sans compter les espacements minimaux entre les transistors (en prenant en compte les espacements donnés plus avant à titre d'exemple, on peut atteindre une empreinte surfacique d'environ 2,56 µm²).

On recherche à réduire cette empreinte surfacique, tout en respectant les règles de conception.

La figure 1B représente, par une vue de dessus simplifiée et partielle, un autre exemple de transistor MOS 100', du type MV ou HV, qui se distingue du transistor 100 principalement en ce que la deuxième région 122' de la structure de grille 120' comprend une encoche 124 en vis-à-vis du contact 133 de la première région 121'. Cette encoche 124 permet de rapprocher le contact 133 vers la deuxième région 122' dans la direction transversale Y, et ainsi de réduire le débord WD1, qui devient WD3, tout en respectant les autres dimensions et notamment en respectant les règles de conception. L'encoche 124 présente une largeur W24 inférieure à la largeur W12 de la deuxième région 122', et elle s'arrête avant la zone active 110, et une longueur L24 inférieure à la longueur L11 de la première région 121'.

Ainsi, on voit qu'on peut réduire la largeur W11' de première région 121', et donc la largeur WO' du transistor MOS 100', et l'empreinte surfacique de celui-ci. En d'autres termes, la largeur W11', respectivement la largeur WO', de la figure 1B est inférieure à la largeur W11, respectivement la largeur WO, de la figure 1A, toutes autres dimensions comparables. La réduction de largeur ΔWO du transistor MOS 100' est par exemple comprise entre 80 et 100 nm.

En reprenant l'exemple de dimensions indiqué plus avant, avec une réduction de largeur ΔWO de 80 nm, le transistor MOS 100' occupe une largeur WO' d'environ 0,9 µm et une longueur L0 d'environ 1,67 µm, soit une empreinte surfacique d'environ 1,50 µm², sans compter les espacements minimaux entre les transistors, ce qui permet un gain en surface d'environ 8% par rapport au transistor MOS 100 de la figure 1A.

Cependant on cherche à réduire davantage cette empreinte surfacique, et ce, toujours en respectant les règles de conception, et sans dégrader les performances électriques attendues du transistor MOS, en particulier pour les transistors MOS MV et HV.

Les inventeurs proposent un transistor MOS permettant de répondre aux besoins d'amélioration décrits précédemment, et de pallier tout ou partie des inconvénients des transistors MOS décrits précédemment.

Des modes de réalisation de transistors MOS vont être décrits ci-après. Les modes de réalisation décrits sont non limitatifs et diverses variantes et/ou combinaisons de modes de réalisation apparaîtront à la personne du métier à partir des indications de la présente description.

De préférence, dans l'ensemble des modes de réalisation décrits plus après, la première région déborde de part et d'autre de la zone active dans la direction transversale Y, et la deuxième région déborde de part et d'autre de la zone active dans la direction transversale Y.

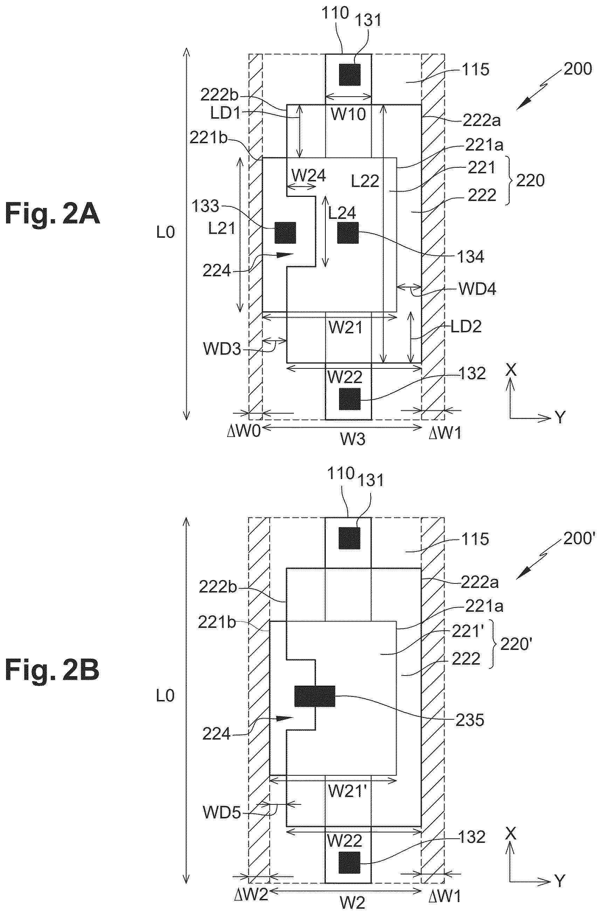

La figure 2A représente, par une vue de dessus simplifiée et partielle, un transistor MOS 200 selon un mode de réalisation.

Le transistor MOS 200 comprend de nombreux éléments communs avec le transistor MOS 100' de la figure 1B, ces éléments communs gardent les mêmes références numériques et ne seront pas détaillés à nouveau dans ce qui suit.

Similairement au transistor MOS 100' de la figure 1B, le transistor MOS 200 comprend une zone active 110, entourée par des tranchées isolantes 115, et une structure de grille 220 isolée de la zone active 110 par une couche d'isolant de grille (non représentée), par exemple une couche d'oxyde. La structure de grille 220 comprend une première région 221 ayant une longueur L21 et une deuxième région 222 située au-dessus de la première région 221 et isolée de celle-ci par une autre couche isolante (non représentée), qui peut être une couche dite ONO, pour Oxyde-Nitrure-Oxyde. La deuxième région 222 a une longueur L22 supérieure à la longueur L21. La deuxième région 222 possède une zone centrale sous la première région 221 et deux parties LD1 et LD2 débordant de part et d'autre de la première région 221 dans la direction longitudinale X (première direction).

Le transistor MOS 200 de la figure 2A se distingue du transistor MOS 100' de la figure 1B principalement en ce que la deuxième région 222 déborde d'au moins un bord longitudinal 221a de la première région 221 dans la direction transversale Y (deuxième direction). En d'autres termes, le bord longitudinal 222a de la deuxième région 222 s'étend dans la direction Y au-delà d'un bord longitudinal 221a de la première région 221. Ainsi, par rapport au transistor MOS 100' de la figure 1B, le débord WD2 de la première région 121 par rapport à la deuxième région 122 dans la direction Y est supprimé, ce qui créé une réduction de largeur ΔW1 au moins égale au débord WD2. En revanche, un débord WD4 de la deuxième région 222 par rapport à la première région 221 dans la direction transversale Y est formé.

Ainsi, la largeur W21 de la première région 221, respectivement la largeur W1 du transistor MOS 200, est inférieure à la largeur W11' de la première région 121, respectivement la largeur WO' du transistor MOS 100', toutes autres dimensions comparables.

Le concepteur pourra réduire la largeur de la première région 221, c'est-à-dire augmenter le débord WD4, tant qu'il constate que cela ne perturbe pas le fonctionnement du transistor MOS 200.

Par ailleurs, étant donné qu'on agit sur les largeurs pour réduire la surface, il est possible de conserver la même longueur L21 de la première région 221, la même longueur L22 de la deuxième région 222, ainsi que les mêmes débords LD1 et LD2 de la deuxième région 222, ce qui permet de conserver les performances/points de fonctionnement du transistor MOS 200, notamment par rapport au transistor MOS 100' de la figure 1B.

Similairement au transistor MOS 100' de la figure 1B, la deuxième région 222 présente une encoche 224 en vis-à-vis du bord longitudinal 221b, opposé au bord longitudinal 221a, de la première région 221. L'encoche 224 est similaire à l'encoche 124 de la figure 1B, et elle est également en vis-à-vis du contact 133 sur la première région 221, permettant de rapprocher ce contact 133 vers la deuxième région 222.

L'encoche 224 s'étend à partir du bord longitudinal 222b de la deuxième région 222, opposé au bord longitudinal 222a, elle présente une largeur W24 inférieure à la largeur W22 de la deuxième région 222.

De préférence, l'encoche 224 s'arrête avant le bord longitudinal 221a de la première région 221. Cela permet d'éviter un vide entre la première région 221 et la deuxième région 222, et ainsi par exemple d'éviter la formation de pièges à charge et/ou de toute insertion dans ce vide, ce qui pourrait induire des problèmes de défectivité et/ou compromettre la fiabilité du transistor MOS.

Par exemple, l'encoche 224 s'arrête avant la zone active 110. Cela permet par exemple de pouvoir aligner les contacts 131, 132, 134 dans la direction X, et ainsi avoir une même largeur de métallisation reliée à ces contacts, favorisant la compacité de la structure d'interconnexion (BEOL).

Par exemple, l'encoche 224 présente une longueur L24 inférieure à la longueur L21 de la première région 221. L'encoche 224 permet de conserver la réduction de largeur ΔWO du transistor 100' de la figure 1B.

En reprenant l'exemple de dimensions indiqué plus avant, avec une réduction de largeur ΔW1 égale à WD2, soit 100 nm, le transistor MOS 200 occupe une largeur W1 d'environ 0,8 µm et une longueur L0 d'environ 1,67 µm, soit une empreinte surfacique d'environ 1,33 µm², sans compter les espacements minimaux entre les transistors, soit un gain en surface d'environ 11% par rapport au transistor MOS 100' de la figure 1B.

Dans ce mode de réalisation, la première région 221 déborde, du côté de son bord longitudinal 221b opposé au bord longitudinal 221a, de la deuxième région 222 dans la direction transversale Y, similairement au transistor MOS 100' de la figure 1B. Ceci n'est pas limitatif, comme le montrent d'autres modes de réalisation décrits plus après.

En variante au mode de réalisation représenté en figure 2A, la deuxième région 222 pourrait ne pas déborder de la première région 221 mais être à la limite du bord longitudinal 221a de la première région 221 dans la direction transversale Y. En d'autres termes, le bord longitudinal 222a de la deuxième région 222 pourrait être positionné à la même cote dans la direction Y que le bord longitudinal 221a de la première région 221. Dit autrement, le débord WD4 pourrait être égal à zéro. On garderait une réduction de largeur ΔW1 égale à WD2.

Les première et deuxième régions 221 et 222 de grille sont de préférence connectées entre elles, par exemple par les contacts 133, 134 de ces régions de grille et une métallisation située dans un niveau de métallisation d'une structure d'interconnexion (non représentée), par exemple un premier niveau de métal.

La figure 2B représente, par une vue de dessus simplifiée et partielle, un transistor MOS 200' selon une variante de réalisation du transistor MOS 200 de la figure 2A.

Le transistor MOS 200' comprend de nombreux éléments communs avec le transistor MOS 200 de la figure 2A, ces éléments communs gardent les mêmes références numériques et ne seront pas détaillés à nouveau dans ce qui suit.

Le transistor MOS 200' de la figure 2B se distingue du transistor MOS 200 de la figure 2A principalement en ce que, au lieu d'avoir un contact 133 sur la première région 221 et un contact 134 distinct sur la deuxième région 222, on prévoit un contact partagé 235 à cheval, dans la direction transversale Y, sur la première région 221' et la deuxième région 222 de la structure de grille 220'. Le contact partagé 235 correspond par exemple à un double contact. La connexion du contact partagé 235 sur la première région 221' est réalisée dans l'encoche 224, qui est similaire à l'encoche 224 de la figure 2A.

Par exemple, le contact partagé 235 présente une largeur dans la direction Y, comprise entre 2 et 3 fois la largeur d'un simple contact du type des contacts 131 et 132. Par exemple, la largeur du contact partagé 235 dans la direction Y est égale à environ 2 fois la largeur du simple contact dans un dispositif électronique dense, ou est comprise entre 2,5 et 3 fois la largeur du simple contact dans un dispositif électronique moins dense. Par exemple, le contact partagé 235 présente une longueur dans la direction X, sensiblement égale à la longueur du simple contact.

Cette variante permet de réduire davantage, par rapport au mode de réalisation de la figure 2A, la largeur W21' de la première région 221', et donc d'autant la largeur W2 du transistor MOSFET 200' (réduction de largeur ΔW2 supérieure à ΔWO). Ainsi, la largeur W21' de la première région 221', respectivement la largeur W2 du transistor MOSFET 200', est inférieure à la largeur W21 de la première région 221, respectivement la largeur W1 du transistor MOSFET 200, toutes autres dimensions comparables. Le débord WD3 est de ce fait également réduit et devient WD5.

En reprenant l'exemple de dimensions indiqué plus avant, avec une réduction de largeur ΔW2 égale à environ 60 nm, le transistor MOS 200' occupe une largeur W2 d'environ 0,74 µm et une longueur L0 d'environ 1,67 µm, soit une empreinte surfacique d'environ 1,23 µm², sans compter les espacements minimaux entre les transistors, soit un gain en surface d'environ 18% par rapport au transistor MOS 100' de la figure 1B.

Dans le mode de réalisation de la figure 2B, la deuxième région 222 est sensiblement similaire à celle de la figure 2A.

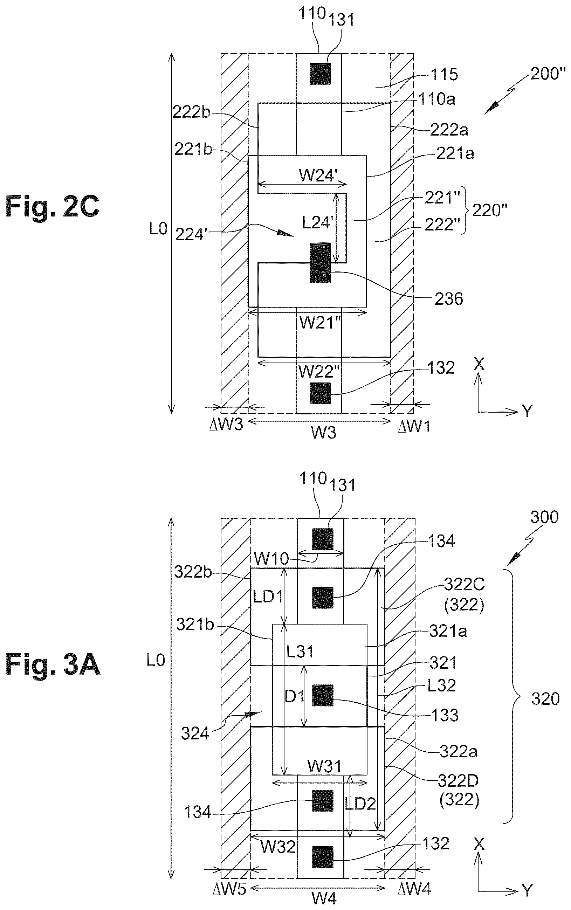

La figure 2C représente, par une vue de dessus simplifiée et partielle, un transistor MOS 200'' selon une autre variante de réalisation du transistor MOS 200 de la figure 2A.

Le transistor MOS 200'' comprend de nombreux éléments communs avec le transistor MOS 200 de la figure 2A, ces éléments communs gardent les mêmes références numériques et ne seront pas détaillés à nouveau dans ce qui suit.

Le transistor MOS 200'' de la figure 2C se distingue du transistor MOS 200 de la figure 2A principalement en ce que l'encoche 224' de la deuxième région 222" de la structure de grille 220'' s'étend, dans la direction transversale Y, au moins jusqu'au-dessus de la zone active 110, ou au bord 110a de la zone active 110 le plus proche du bord longitudinal 221a, voire légèrement au-delà de ce bord 110a, de sorte à ce que le contact 236 de la première région 221" de la structure de grille 220'' puisse être positionné au regard de la zone active 110. Par exemple, les contacts 131, 132, 236 sont sensiblement alignés dans la direction X. Cela permet notamment que la métallisation, par exemple le premier niveau de métal de la structure d'interconnexion (BEOL), qui relie les contacts 131, 132 et 236 puisse avoir sensiblement la même largeur le long de la direction X, favorisant la compacité de la structure d'interconnexion, et rendant ainsi le transistor MOS 200'' plus compact dans la direction Y. Ainsi, l'encoche 224' a une largeur W24' qui est supérieure à la largeur W24 de l'encoche 224 des figures 2A et 2B, tandis que sa longueur L24' peut être égale à ou différente de la longueur L24 de l'encoche 224 des figures 2A et 2B.

Comme l'encoche 224 de la figure 2A, de préférence, l'encoche 224' s'arrête avant le bord longitudinal 221a de la première région 221''. Cela permet d'éviter un vide entre la première région 221'' et la deuxième région 222'', et ainsi par exemple d'éviter la formation de pièges à charge et/ou de toute insertion dans ce vide, ce qui pourrait induire des problèmes de défectivité et/ou compromettre la fiabilité du transistor MOS.

Cette variante permet en outre de réduire encore davantage, par rapport au mode de réalisation de la figure 2B, la largeur W21'' de la première région 221'', et donc d'autant la largeur W3 du transistor MOSFET 200'' (réduction de largeur ΔW3 supérieure à ΔW2). Ainsi, la largeur W21'' de la première région 221'', respectivement la largeur W3 du transistor MOSFET 200'', est inférieure à la largeur W21' de la première région 221', respectivement la largeur W2 du transistor MOSFET 200', toutes autres dimensions comparables.

En outre, dans cet exemple, on prévoit un contact partagé 236 à cheval, dans la direction longitudinale X, sur la première région 221'' et la deuxième région 222''. En variante, on pourrait prévoir un contact partagé dans la direction transversale Y, ou un contact sur la première région 221" et un autre contact distinct sur la deuxième région 222''. En variante, le contact partagé 236 pourrait ne pas être au-dessus de la zone active 110.

Par exemple, le contact partagé 236 présente une longueur dans la direction X, comprise entre 2 et 3 fois la longueur d'un simple contact du type des contacts 131 et 132. Par exemple, la longueur du contact partagé 236 dans la direction X est égale à environ 2 fois la longueur du simple contact dans un dispositif électronique dense, ou est comprise entre 2,5 et 3 fois la longueur du simple contact dans un dispositif électronique moins dense. Par exemple, le contact partagé 236 présente une largeur dans la direction Y, sensiblement égale à la largeur du simple contact.

En reprenant l'exemple de dimensions indiqué plus avant, avec une réduction de largeur ΔW3 égale à environ 80 nm, le transistor MOS 200'' occupe une largeur W3 d'environ 0,72 µm et une longueur L0 d'environ 1,67 µm, sans compter les espacements minimaux entre les transistors, soit une empreinte surfacique d'environ 1,20 µm², et un gain en surface d'environ 20% par rapport au transistor MOS 100' de la figure 1B.

La figure 3A représente, par une vue de dessus simplifiée et partielle, un transistor MOS 300 selon un autre mode de réalisation.

Le transistor MOS 300 comprend de nombreux éléments communs avec le transistor MOS 200 de la figure 2A, ces éléments communs gardent les mêmes références numériques et ne seront pas détaillés à nouveau dans ce qui suit.

En particulier, similairement au transistor MOS 200 de la figure 2A, le transistor MOS 300 comprend une zone active 110 et une structure de grille 320 isolée de la zone active 110 par une couche d'isolant de grille (non représentée), par exemple une couche d'oxyde. La structure de grille 320 comprend une première région 321 ayant une longueur L31 et une deuxième région 322 située au-dessus de la première région 321 et isolée de celle-ci par une autre couche isolante (non représentée), qui peut être une couche dite ONO, pour Oxyde-Nitrure-Oxyde. La deuxième région 322 a une longueur totale L32 supérieure à la longueur L31 de la première région 321. La deuxième région 322 présente des débords LD1 et LD2 de part et d'autre de la première région 321 dans la direction longitudinale X (première direction).

Le transistor MOS 300 de la figure 3A se distingue du transistor MOS 200 de la figure 2A principalement en ce que la deuxième région 322 de grille est en deux parties distinctes, une première partie 322C et une deuxième partie 322D, séparées entre elles par une distance D1 non nulle dans la direction longitudinale X. En outre, la deuxième région 322 s'étend de part et d'autre de la première région 321 dans la direction transversale Y. La largeur W31 de la première région 321 est inférieure à la largeur W32 de la deuxième région 322.

Ce mode de réalisation permet de réaliser les contacts 133, 134 des première et deuxième régions dans l'ouverture 324 entre les deux parties 322C et 322D de la deuxième région 322 de grille. Ainsi, de préférence, on choisit une distance D1 qui permette de respecter les distances minimales, selon les règles de conception, entre le contact 133 sur la première région 321 et chaque partie 322C, 322D de la deuxième région 322. Chaque partie 322C, 322D a son propre contact 134.

Ce mode de réalisation permet de réduire encore davantage, par rapport au mode de réalisation de la figure 2A, voire des modes de réalisation des figures 2B et 2C, la largeur W31 de la première région 321, et ce, à la fois du côté du bord longitudinal 321a (réduction de largeur ΔW4) et du bord longitudinal 321b (réduction de largeur ΔW5) de la première région 321. Cette configuration permet donc de de réduire d'autant la largeur W4 du transistor MOSFET 300. Ainsi, la largeur W31 de la première région 321, respectivement la largeur W4 du transistor MOSFET 300, est inférieure à la largeur W21 de la première région 221, respectivement la largeur W1, du transistor MOSFET 200, toutes autres dimensions comparables.

On peut voir l'ouverture 324 entre les deux parties 322C et 322D de la deuxième région 322 comme un prolongement de l'encoche 224 ou 224' des figures 2A, 2B et 2C entre les deux bords longitudinaux 322a et 322b de la deuxième région 322 de manière à séparer la deuxième région 322 en ces deux parties.

Les deux parties 322C et 322D présentent de préférence la même largeur, égale à la largeur W32 de la deuxième région 322. Les deux parties 322C et 322D peuvent présenter, ou non, la même longueur. La longueur totale L32 de la deuxième région 322 est égale à la somme des longueurs des deux parties 322C et 322D et de la distance D1 entre ces deux parties.

En reprenant l'exemple de dimensions indiqué plus avant, avec ΔW4 et ΔW5 égales à environ 80 nm, soit une réduction de largeur égale à 160 nm, le transistor MOS 300 seul occupe une largeur W4 d'environ 0,64 µm et une longueur L0 d'environ 1,67 µm, soit une empreinte surfacique d'environ 1,07 µm², sans compter les espacements minimaux entre les transistors, soit un gain en surface d'environ 20% par rapport au transistor MOS 200 de la figure 2A, et d'environ 29% par rapport au transistor MOS 100' de la figure 1B.

Par ailleurs étant donné qu'on agit sur les largeurs pour réduire la surface, il est possible de conserver la même longueur L31 de la première région 321, la même longueur L32 de la deuxième région 322, ainsi que les mêmes débords LD1 et LD2 de la deuxième région 322 (débord LD1 de la première partie 322C et débord LD2 de la deuxième partie 322D), ce qui permet de conserver les performances/points de fonctionnement du transistor MOS 300, notamment par rapport au transistor MOS 100' de la figure 1B.

Les première et deuxième régions 321 et 322 de grille sont de préférence connectées entre elles, par exemple par les contacts 133, 134 de ces régions de grille et une métallisation située dans un niveau de métallisation d'une structure d'interconnexion (non représentée), par exemple un premier niveau de métal.

Par exemple, les contacts 131, 132, 133, 134 sont sensiblement alignés dans la direction X. Cela permet notamment que la métallisation reliée à ces contacts puisse avoir sensiblement la même largeur, favorisant la compacité de la structure d'interconnexion.

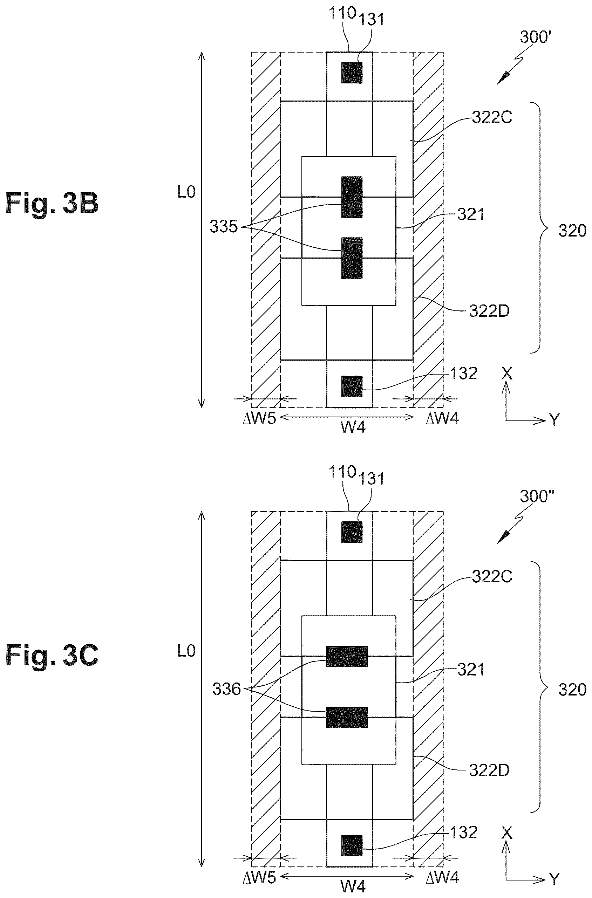

La figure 3B représente, par une vue de dessus simplifiée et partielle, un transistor MOS 300' selon une variante de réalisation du transistor MOS de la figure 3A.

Le transistor MOS 300' comprend de nombreux éléments communs avec le transistor MOS 300 de la figure 3A, ces éléments communs gardent les mêmes références numériques et ne seront pas détaillés à nouveau dans ce qui suit.

Le transistor MOS 300' de la figure 3B se distingue du transistor MOS 300 de la figure 3A principalement en ce que, au lieu d'avoir un contact 133 sur la première région 321 et un contact 134 distinct sur chacune des parties 322C et 322D de la deuxième région 322, on prévoit un contact partagé 335 à cheval, dans la direction longitudinale X, sur la première région 321 et sur chacune des parties 322C et 322D de la deuxième région 322.

Par exemple, chaque contact partagé 335 présente une largeur dans la direction Y, comprise entre 2 et 3 fois la largeur d'un simple contact du type des contacts 131 et 132. Par exemple, la largeur de chaque contact partagé 335 dans la direction Y est égale à environ 2 fois la largeur du simple contact dans un dispositif électronique dense, ou est comprise entre 2,5 et 3 fois la largeur d'un simple contact dans un dispositif électronique moins dense. Par exemple, chaque contact partagé 335 présente une longueur dans la direction X, sensiblement égale à la longueur du simple contact.

Cette variante permet que la métallisation, par exemple le premier niveau de métal de la structure d'interconnexion, qui relie les contacts 131, 132 et 335 puisse avoir sensiblement la même largeur le long de la direction X, rendant ainsi le transistor MOS 300' plus compact dans la direction Y. On pourrait ainsi réduire la largeur W4 par rapport à la figure 3A et/ou à la figure 3C décrite ci-après.

Par exemple, les contacts 131, 132, 335 sont sensiblement alignés dans la direction X. Cela permet notamment que la métallisation reliée à ces contacts puisse avoir sensiblement la même largeur, favorisant la compacité de la structure d'interconnexion.

La figure 3C représente, par une vue de dessus simplifiée et partielle, un transistor MOS selon une variante de réalisation du transistor MOS de la figure 3B.

Le transistor MOS 300'' comprend de nombreux éléments communs avec le transistor MOS 300' de la figure 3B, ces éléments communs gardent les mêmes références numériques et ne seront pas détaillés à nouveau dans ce qui suit.

Le transistor MOS 300'' de la figure 3C se distingue du transistor MOS 300' de la figure 3B principalement en ce que, au lieu d'un contact partagé dans la direction longitudinale X, on prévoit un contact partagé 336 à cheval, dans la direction transversale Y, sur la première région 321 et sur chacune des parties 322C et 322D de la deuxième région 322.

Par exemple, chaque contact partagé 336 présente une longueur dans la direction X, comprise entre 2 et 3 fois la longueur d'un simple contact du type des contacts 131 et 132. Par exemple, la longueur de chaque contact partagé 336 dans la direction X est égale à environ 2 fois la longueur du simple contact dans un dispositif électronique dense, ou est comprise entre 2,5 et 3 fois la longueur du simple contact dans un dispositif électronique moins dense. Par exemple, chaque contact partagé 336 présente une largeur dans la direction Y, sensiblement égale à la largeur du simple contact.

Par exemple, les contacts 131, 132, 336 sont sensiblement alignés dans la direction X. Cela permet notamment que la métallisation reliée à ces contacts puisse avoir sensiblement la même largeur, favorisant la compacité de la structure d'interconnexion.

Cette variante permet d'augmenter les surfaces de contact de chaque contact partagé 336 à la fois avec la première région 321 et la deuxième région 322.

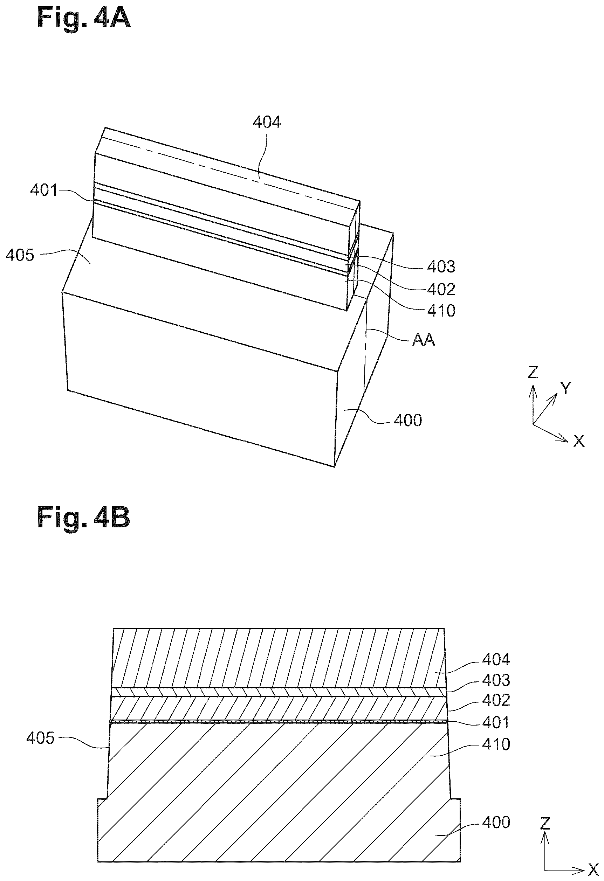

La figure 4A, la figure 4B, la figure 5A, la figure 5B, la figure 6A, la figure 6B, la figure 7A, la figure 7B, la figure 8A, la figure 8B, la figure 9A, la figure 9B, la figure 10A, la figure 10B, la figure 11A, et la figure 11B sont des vues en trois dimensions et en coupe longitudinale, illustrant de façon partielle et schématique des étapes successives d'un procédé de fabrication d'un transistor MOS selon un mode de réalisation.

Les coupes longitudinales sont réalisées selon le plan de coupe AA repéré dans les vues en trois dimensions.

Les figures 4A et 4B illustrent une structure de départ comprenant une couche 401 d'oxyde de silicium sur un substrat semiconducteur 400, une couche 402 de masque dur, par exemple un nitrure de silicium, sur la couche 401, une couche 403 d'oxyde de silicium sur la couche 402, et un masque de gravure 404, par exemple une résine photosensible, sur la couche 403.

Une zone active 410 entourée par des tranchées 405 a été formée par gravure à travers le masque de gravure 404.

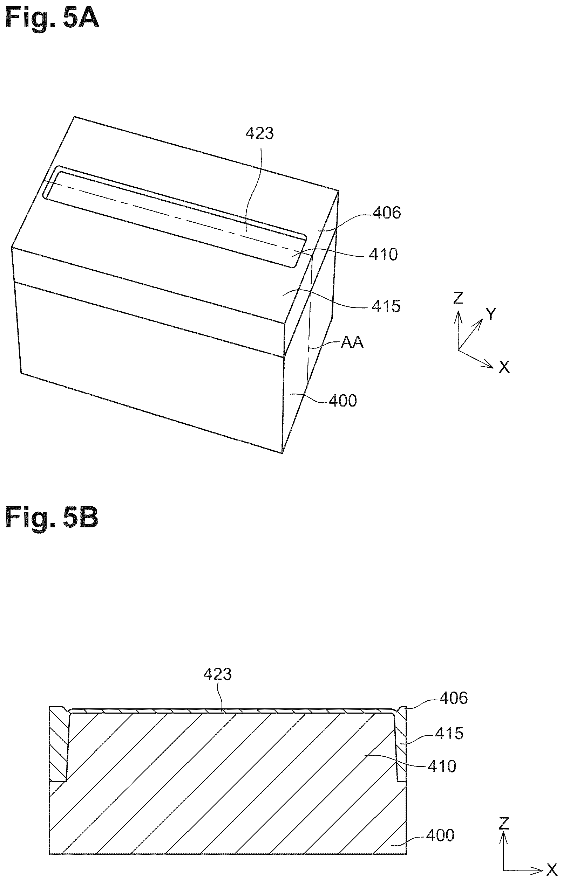

Les figures 5A et 5B illustrent une structure obtenue à l'issue de la suppression du masque de gravure 404 et des couches 402, 403, voire de la couche 401 d'oxyde de silicium, et du dépôt d'une autre couche 406 d'oxyde de silicium sur le substrat semiconducteur 400 et dans les tranchées 405, formant une couche d'isolant de grille 423, ou isolant de grille 423, sur la zone active 410, et des tranchées isolantes 415 autour de la zone active 410.

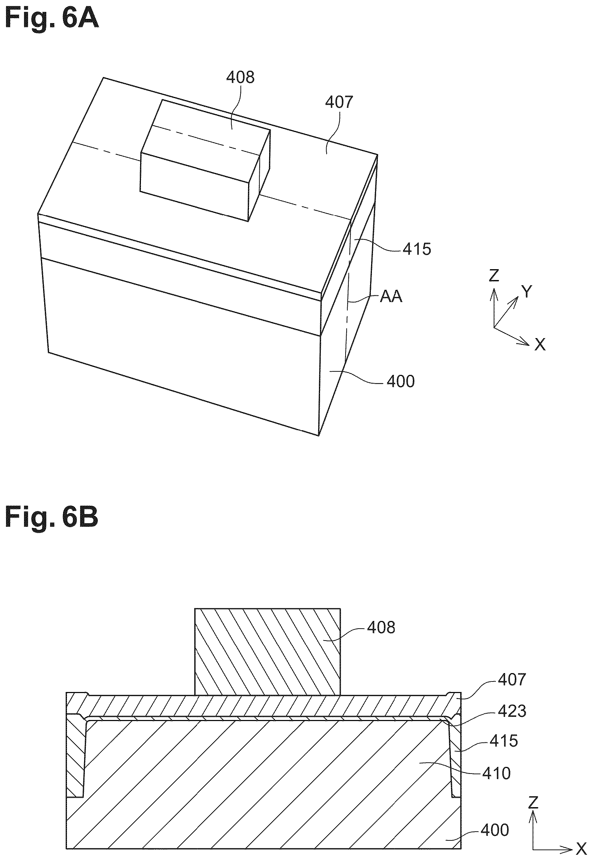

Les figures 6A et 6B illustrent une structure obtenue à l'issue du dépôt d'une couche 407 de silicium polycristallin, ou polysilicium, sur la couche d'isolant de grille 423 et les tranchées isolantes 415, et d'un masque de gravure 408, par exemple une résine photosensible, sur la couche 407 de polysilicium.

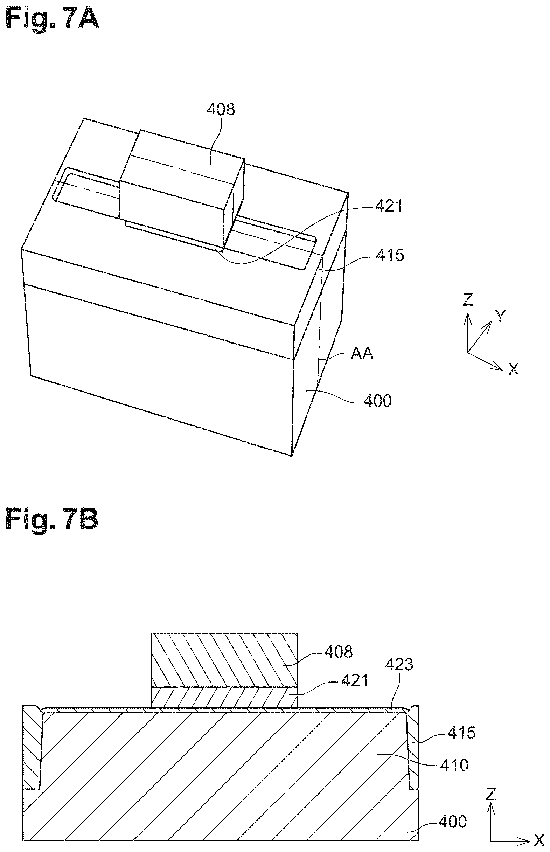

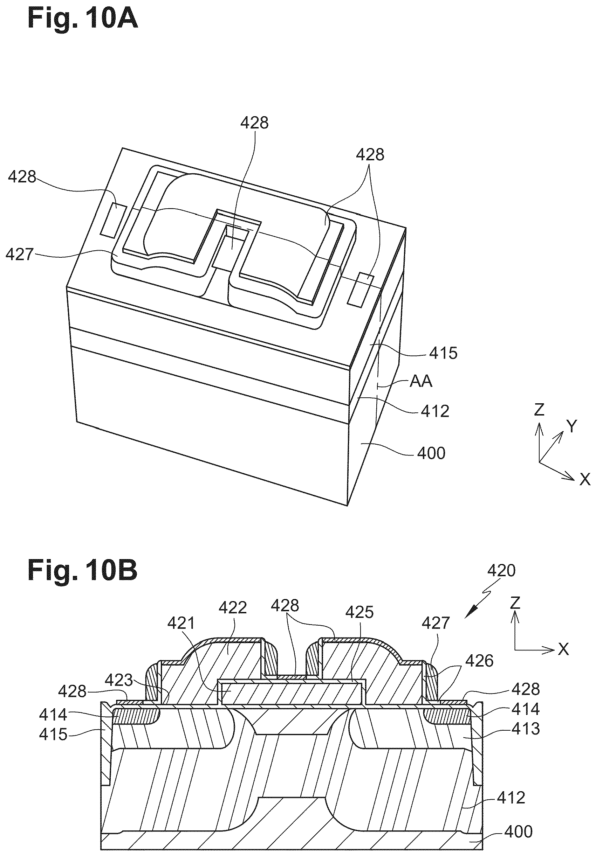

Les figures 7A et 7B illustrent une structure obtenue à l'issue de la gravure de la couche 407 de polysilicium à travers le masque de gravure 408, formant une première région 421 d'une structure de grille 420 (représentée dans les figures 10A et 10B). Le masque de gravure 408 est ensuite retiré.

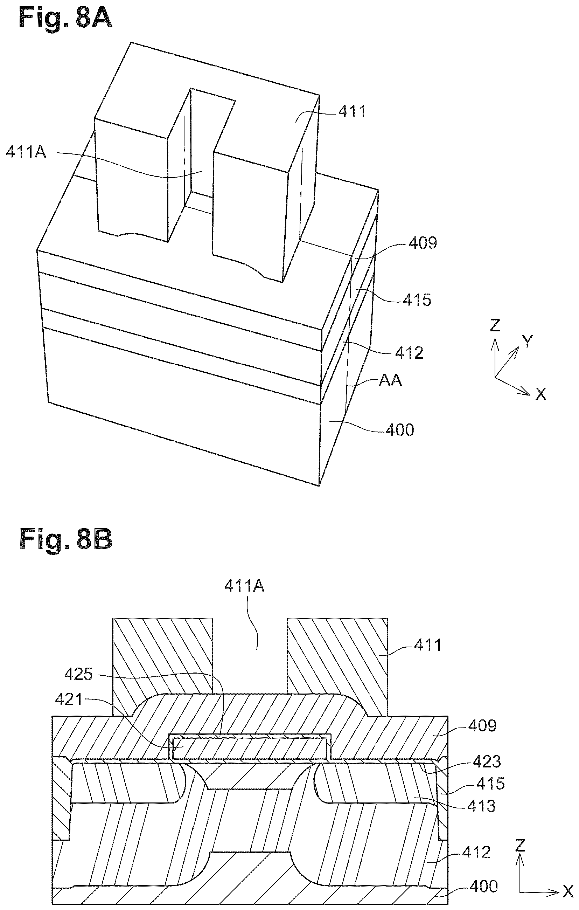

Les figures 8A et 8B illustrent une structure obtenue à l'issue de la formation d'un caisson 412 dans le substrat semiconducteur 400 et de régions faiblement dopées 413, ou LDD de l'anglais "Lightly Doped Drain", dans le caisson 412, puis du dépôt d'une couche d'isolant du type ONO 425, ou couche d'isolant inter-grilles 425, sur le dessus et les flancs de la première région 421, d'une couche 409 de polysilicium sur la première région 421 isolée par la couche d'isolant inter-grilles 425, et sur l'isolant de grille 423, et d'un masque de gravure 411, par exemple une résine photosensible, sur la couche 409 de polysilicium. Le masque de gravure présente une ouverture 411A au-dessus de la première région 421, sous la forme d'une encoche dans la direction Y, pour réaliser une future encoche dans la couche 409 de polysilicium. La couche 409 de polysilicium s'étend également de part et d'autre et autour de la première région 421 dans la direction X, sur la couche d'isolant de grille 423. En d'autres termes, la couche 409 de polysilicium s'étend contre les flancs de la première région 421 isolée par la couche d'isolant inter-grilles 425.

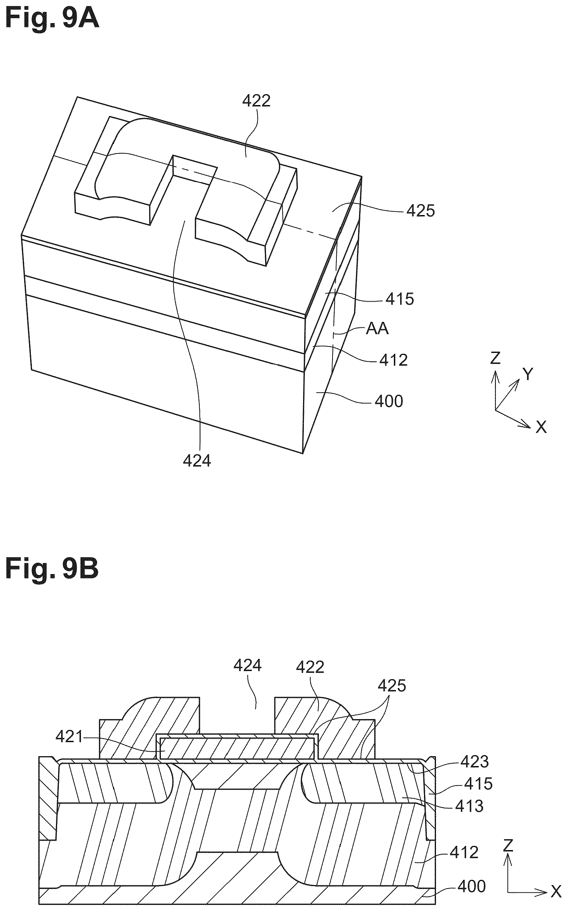

Les figures 9A et 9B illustrent une structure obtenue à l'issue de la gravure de la couche 409 de polysilicium au travers du masque de gravure 411, formant une deuxième région 422 de la structure de grille 420 (représentée dans les figures 10A et 10B). Cette gravure permet de former, dans la deuxième région 422, une encoche 424 qui s'étend dans la direction Y jusqu'au-dessus de la première région 421. Le masque de gravure 411 est ensuite retiré. On a représenté une encoche 424 similaire à l'encoche 224' de la figure 2C, mais l'encoche 424 pourrait être similaire à l'encoche 224 de la figure 2A, ou encore similaire à l'ouverture 324 de la figure 3A.

Les figures 10A et 10B illustrent une structure obtenue à l'issue de la formation de régions de source et de drain 414 dans les régions LDD 413, du dépôt d'une couche d'oxyde de silicium 426 sur les flancs de la deuxième région 422 et sur une portion de la couche d'isolant inter-grilles 425 autour de la deuxième région 422, puis de la formation d'espaceurs 427 en nitrure de silicium sur la couche d'oxyde de silicium 426, et ainsi sur les flancs de la deuxième région 422.

Des couches de siliciure 428 sont ensuite déposées sur les régions de source et de drain 414, sur une portion découverte de la première région 421 et sur la deuxième région 422. On obtient une structure de grille 420 à double région de grille.

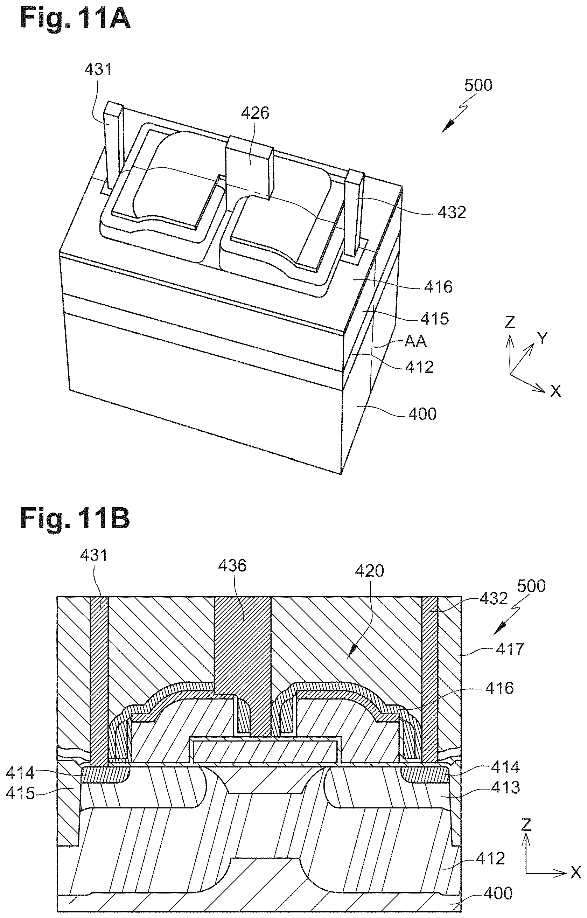

Les figures 11A et 11B illustrent une structure obtenue à l'issue de la formation d'une couche 416 de nitrure de silicium sur la structure des figures 10A et 10B, puis d'une couche isolante 417 dite PMD, de l'anglais « Pre Metal Dielectric », qui peut être un oxyde de silicium, sur la couche 416. Des contacts sont formés au travers de la couche PMD 417 et de la couche 416 : deux contacts 431 et 432 viennent connecter les portions siliciurées des régions de source et de drain 414, et un contact partagé 436 vient connecter la fois la première région 421 de grille dans l'encoche 424 et la deuxième région 422 de grille.

Le transistor MOS obtenu 500 est similaire au transistor 200'' de la figure 2C. La personne du métier saura adapter le procédé de fabrication pour obtenir un transistor MOS selon tout autre mode de réalisation.

On voit que la première région 421 de la structure de grille 420 est positionnée sur l'isolant de grille 423, qu'elle est recouverte de la couche d'isolant inter-grilles 425, et la deuxième région 422 est positionnée à cheval sur la couche d' 'isolant inter-grilles 425 et sur la couche d'isolant de grille 423. En particulier, la deuxième région 422 est positionnée de part et d'autre, et autour, de la première région 421 au moins dans la direction X. La première région 421 n'est pas encapsulée à l'intérieur d'une seule couche isolante. La deuxième région 422 a au moins une portion située au-dessus de la première région 421. Cela permet que la deuxième région 422 puisse être contactée avec la première région 421, et ne soit pas flottante. Ces caractéristiques s'appliquent également de préférence pour toutes les structures de grille 220, 320 décrites plus avant.

Il est ainsi possible de fabriquer un transistor MOS selon les modes de réalisation en mettant en œuvre un procédé standard de la microélectronique, par exemple dans une ligne de fabrication standard, et ce, sans coût supplémentaire.

Le transistor MOSFET selon les modes de réalisation peut être intégré dans un circuit électronique, par exemple un circuit intégré. Le transistor MOSFET selon les modes de réalisation peut faire partie d'une cellule de mémoire non volatile, par exemple une mémoire du type EEPROM. Le transistor MOSFET selon les modes de réalisation peut notamment former un transistor de sélection d'une cellule de mémoire du type EEPROM.

De nombreuses applications sont susceptibles de tirer profit des avantages procurés par le transistor MOSFET selon les modes de réalisation, et par exemple par une mémoire du type EEPROM comprenant un ou plusieurs de ces transistors MOSFET, le transistor MOSFET pouvant ainsi être intégré dans divers types de dispositifs.

À titre d'exemple, le transistor MOSFET peut être intégré dans un dispositif destiné à l'industrie automobile. L'électrification des véhicules automobiles cause une forte augmentation du nombre de composants électroniques présents dans les véhicules. Par ailleurs, l'aide à la conduite et l'automatisation de la conduite sont à l'origine d'une augmentation du nombre de composants électroniques dans les véhicules. La réduction de l'empreinte surfacique des composants électroniques présente donc un avantage.

À titre d'exemple, le transistor MOSFET peut être intégré dans un dispositif destiné à l'industrie. En particulier, le dispositif est par exemple utilisé pour le développement des énergies vertes ou pour l'électrification d'infrastructures, par exemple pour des bornes de recharge ou pour la collecte d'énergie solaire. Le dispositif peut également être utilisé dans le domaine de l'internet des objets ou dans le domaine des maisons connectées. Le dispositif peut également être utilisé pour la mise en œuvre de systèmes d'informatique dans le cloud, ou nuage, de réseaux de communication radiofréquence 5G, de centres de données et de serveurs.

À titre d'exemple, le transistor MOSFET peut être intégré dans un dispositif destiné à être utilisé dans l'électronique personnelle, par exemple dans le but d'augmenter un volume d'informations échangées par communication radiofréquence, dans des systèmes de communication 5G, ou plus généralement dans tout dispositif connecté. Le dispositif est par exemple un téléphone mobile, ou smartphone, ou fait partie d'un réseau de l'internet des objets.

À titre d'exemple, le transistor MOSFET peut être intégré dans un dispositif destiné à être utilisé dans des équipements de communication, ou dans des ordinateurs et des périphériques. Le dispositif est par exemple utilisé dans des infrastructures 5G et des centres de données dédiés.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Transistor MOSFET (200 ; 200' ; 200'' ; 300 ; 300' ; 300'') situé dans et sur un substrat semiconducteur s'étendant selon un plan (XY), le transistor MOSFET comportant :
- une région de drain et une région de source situées dans une zone active (110) du substrat semiconducteur le long d'une première direction (X) du plan ; et
- une structure de grille (220 ; 220' ; 220'' ; 320) comprenant une première région (221 ; 221' ; 221'' ; 321) isolée de, et située au moins en partie au-dessus de, la zone active, et une deuxième région (222 ; 222'' ; 322) isolée de, et située au-dessus de, la première région ;
la première région ayant une première longueur (L21 ; L31), la deuxième région ayant une deuxième longueur (L22 ; L32) supérieure à la première longueur, et la deuxième région débordant de part et d'autre de la première région dans la première direction (X) ;
la deuxième région ayant un premier bord longitudinal (222a ; 322a) qui atteint la limite, ou qui déborde, d'un deuxième bord longitudinal (221a ; 321a) de la première région, dans une deuxième direction (Y) du plan perpendiculaire à la première direction (X) ;
la deuxième région présentant une ouverture (224 ; 224'' ; 324) qui s'étend dans la deuxième direction (Y) à partir d'un troisième bord longitudinal (222b ; 322b) de ladite deuxième région opposé au premier bord longitudinal.

2. Transistor MOSFET (200 ; 200' ; 200" ; 300 ; 300' ; 300'') selon la revendication 1, dans lequel la zone active (110) a une troisième longueur (L0) supérieure à la deuxième longueur (L22 ; L32), et une troisième largeur (W10) inférieure à une première largeur (W21 ; W21' ; W21'' ; W31) de la première région (221 ; 221' ; 221'' ; 321), et à une deuxième largeur (W22 ; W22'' ; W32) de la deuxième région (222 ; 222'' ; 322), par exemple la première région et/ou la deuxième région est située de part et d'autre que la zone active dans la deuxième direction.

3. Transistor MOSFET (200 ; 200' ; 200'' ; 300 ; 300' ; 300'') selon la revendication 1 ou 2, dans lequel la première région (221 ; 221' ; 221'' ; 321) de la structure de grille (220 ; 220' ; 220'' ; 320) est positionnée sur une couche d'isolant de grille, est recouverte par une couche d'isolant inter-grilles, et la deuxième région (222 ; 222'' ; 322) de la structure de grille est positionnée à cheval, au moins dans la première direction (X), sur la première région recouverte par la couche d'isolant inter-grilles et sur la couche d'isolant de grille.

4. Transistor MOSFET (200 ; 200' ; 200'') selon l'une quelconque des revendications 1 à 3, dans lequel l'ouverture (224 ; 224") de la deuxième région (222 ; 222'') est une encoche qui s'arrête avant le premier bord longitudinal (222a), et par exemple également avant le deuxième bord longitudinal (221a).

5. Transistor MOSFET (200 ; 200' ; 200'') selon la revendication 4, dans lequel :
- l'encoche (224) s'arrête avant la zone active (110) ; ou
- l'encoche (224'') s'étend, par exemple s'arrête, au-dessus de la zone active (110).

6. Transistor MOSFET (300 ; 300' ; 300'') selon l'une quelconque des revendications 1 à 3, dans lequel l'ouverture (324) s'étend jusqu'au premier bord longitudinal (322a), de sorte que la deuxième région (322) est en deux parties (322C, 322D) séparées par l'ouverture.

7. Transistor MOSFET (200 ; 200' ; 200'' ; 300 ; 300' ; 300'') selon l'une quelconque des revendications 1 à 6, dans lequel :
- la deuxième région (222 ; 222'') déborde du deuxième bord longitudinal (221a) dans la deuxième direction (Y), et la première région (221 ; 221' ; 221'') déborde du troisième bord longitudinal (222b) dans la deuxième direction ; ou
- la deuxième région (322) déborde de part et d'autre de la première région (321) dans la deuxième direction (Y), une première largeur (W31) de la première région (321) étant inférieure à une deuxième largeur (W32) de la deuxième région (322).

8. Transistor MOSFET (200 ; 300 ; 200' ; 200'' ; 300' ; 300'') selon l'une quelconque des revendications 1 à 7, comprenant en outre :
- un premier contact (133) sur la première région (221 ; 321) et au moins un deuxième contact (134) sur la deuxième région (222 ; 322), par exemple un deuxième contact pour chaque partie d'une deuxième région (322) en deux parties (322C, 322D), le premier contact (133) étant par exemple positionné au moins partiellement dans l'ouverture ; ou
- au moins un contact partagé (235 ; 236 ; 335 ; 336) à cheval sur la première région (221' ; 221'' ; 321) et sur la deuxième région (222' ; 222'' ; 322), par exemple un contact partagé pour chaque partie d'une deuxième région (322) en deux parties (322C, 322D), le au moins un contact partagé étant par exemple positionné au moins partiellement dans l'ouverture.

9. Transistor MOSFET selon l'une quelconque des revendications 1 à 8, dans lequel :
- la première région de la structure de grille est entre la région de drain et la région de source ; et/ou
- la deuxième région de la structure de grille est entre la région de drain et la région de source ; et/ou
- la région de drain et la région de source sont comprises chacune dans une région de drain faiblement dopée située au moins partiellement sous la deuxième région de la structure de grille ; et/ou
- la zone active (110) est entourée de tranchées isolantes (115), les première et deuxième régions s'étendant également au-dessus desdites tranchées isolantes ; et/ou
- les première et deuxième régions de la structure de grille comprennent du, par exemple sont en, polysilicium.

10. Transistor MOSFET selon l'une quelconque des revendications 1 à 9, le transistor MOSFET étant un transistor de tension moyenne, par exemple entre 10 et 13 volts, ou un transistor de haute tension, par exemple supérieure à 14 volts.

11. Procédé de fabrication d'au moins un transistor MOSFET, le procédé comprenant les étapes successives suivantes, pour chaque transistor MOSFET :
- la formation d'une première région (421) d'une structure de grille (420), ladite première région étant isolée et au-dessus d'une zone active (410) d'un substrat semiconducteur (400) s'étendant selon un plan (XY), ladite première région ayant une première longueur dans une première direction (X) du plan ;
- la formation d'une deuxième région (422) de la structure de grille (420), ladite deuxième région étant isolée et au-dessus de la première région, ayant une deuxième longueur supérieure à la première longueur, et débordant de part et d'autre de la première région dans la première direction, la deuxième région étant formée de sorte qu'un premier bord longitudinal de ladite deuxième région atteint la limite, ou déborde, d'un deuxième bord longitudinal de la première région, dans une deuxième direction (Y) du plan (XY) perpendiculaire à la première direction (X), et la formation de la deuxième région comprenant la formation d'une ouverture (424) dans ladite deuxième région, dans la deuxième direction (Y) à partir d'un troisième bord longitudinal de ladite deuxième région opposé au premier bord longitudinal ; puis
- la formation de régions de drain et de source (414) de part et d'autre de la deuxième région dans la première direction.

12. Procédé de fabrication selon la revendication 11, comprenant en outre, après la formation de la première région (421), et avant la formation de la deuxième région (422), la formation de régions de drain faiblement dopées (413) de part et d'autre de la première région dans la première direction.

13. Procédé de fabrication selon la revendication 11 ou 12, dans lequel la fabrication du au moins un transistor MOSFET comprend la fabrication de plusieurs transistors MOSFET de types différents choisis parmi : un transistor de tension moyenne, et/ou un transistor de haute tension, et/ou un transistor d'état d'une cellule mémoire, et/ou un transistor de sélection d'une cellule mémoire ;
les premières régions desdits transistors étant formées simultanément et étant de préférence en le même matériau, les deuxièmes régions desdits transistors étant formées simultanément et étant de préférence en le même matériau ; et le procédé de fabrication comprenant :
- avant la formation des premières régions des transistors MOSFET, la formation de couches d'isolant de grille de même matériau et de sensiblement la même épaisseur sur les zones actives des transistors MOSFET ; et/ou
- après la formation des premières régions et avant la formation des deuxièmes régions des transistors MOSFET, la formation de couches oxyde-nitrure-oxyde de sensiblement la même épaisseur sur les premières régions des transistors MOSFET.

14. Circuit électronique comprenant un substrat semiconducteur et au moins un transistor MOSFET selon l'une quelconque des revendications 1 à 13, par exemple le circuit électronique est une mémoire non volatile du type électriquement effaçable et programmable.

15. Circuit électronique selon la revendication 14, dans lequel le au moins un transistor MOSFET comprend plusieurs transistors MOSFET de types différents choisis parmi : un transistor de tension moyenne, et/ou un transistor de haute tension, et/ou un transistor d'état d'une cellule mémoire, et/ou un transistor de sélection d'une cellule mémoire ;
- les premières régions desdits transistors étant de préférence en le même matériau, les deuxièmes régions desdits transistors étant de préférence en le même matériau ; et/ou
- des couches oxyde-nitrure-oxyde de sensiblement la même épaisseur étant positionnées entre les premières régions et les deuxièmes régions desdits transistors ; et/ou
- des couches d'isolant de grille de même matériau et de sensiblement la même épaisseur étant positionnées entre les zones actives et les premières régions desdits transistors.
